# FASCICULE DE BREVET EUROPEEN

(11) **EP 4 338 290 B1**
(45) Date de publication et mention de la délivrance du brevet: **21.01.2026**
(21) Numéro de dépôt: 22727383.6
(22) Date de dépôt: 10.05.2022
(51) Int. Cl.: H03K 17/97, G05G 5/05

(54) **DISPOSITIF DE COMMANDE**
STEUERVORRICHTUNG
CONTROL DEVICE

(30) Priorité: 11.05.2021 FR 2104981
(43) Date de publication de la demande: 20.03.2024
(73) Titulaire: Apem, 82300 Caussade (FR)
(72) Inventeur: SIMON, Charly, 31000 Toulouse (FR)
(74) Mandataire: Regimbeau
(86) Numéro de dépôt international: PCT/FR2022/050897
(87) Numéro de publication internationale: WO 2022/238657

(56) Documents cités:
- EP-A1- 3 677 983
- US-A1- 2018 059 710
- US-B2- 8 284 003

## Description

### DOMAINE DE L'INVENTION

La présente invention concerne un dispositif de commande tel qu'un commutateur à molette.

### ETAT DE LA TECHNIQUE

Les dispositifs de commande à molette sont destinés à être montés sur des poignées de commande, des manettes de contrôle ou toute autre application de commande de différentes machines nécessitant un contrôle précis.

Un tel dispositif de commande comprend un corps fixe, sur lequel est monté un actionneur mobile en rotation autour d'un axe. Pour un dispositif de commande de précision, la course est typiquement limitée par des butées mécaniques, pour limiter le mouvement angulaire par exemple à 25° dans les deux directions.

L'actionneur mobile comprend en outre un élément détectable, par exemple un aimant, dont le mouvement est détecté par un capteur, par exemple un capteur à effet Hall, agencé dans le corps. Ledit capteur produit un signal électrique proportionnel à l'amplitude angulaire du mouvement de l'actionneur.

Le dispositif de commande est typiquement pourvu d'un moyen de rappel vers la position de repos qui peut être un ressort de torsion. Les branches dudit ressort sont agencées en appui sur une paire de surfaces de contact agencées au rotor de l'actionneur mobile et une paire de butées fixées à la portion inférieure du corps. Par portion inférieure, on comprend la portion comprise entre l'axe de rotation et la portion du corps comportant le capteur. Quand on exerce un effort sur l'actionneur afin de le pivoter autour de son axe, on contraint le ressort de torsion contre les butées du côté de la direction du mouvement. Dès que l'effort sur l'actionneur cesse, le ressort de torsion se détend et l'actionneur retourne dans sa position de repos.

Cependant, il existe fréquemment un jeu mécanique résiduel autour de la position de repos dans une telle configuration.

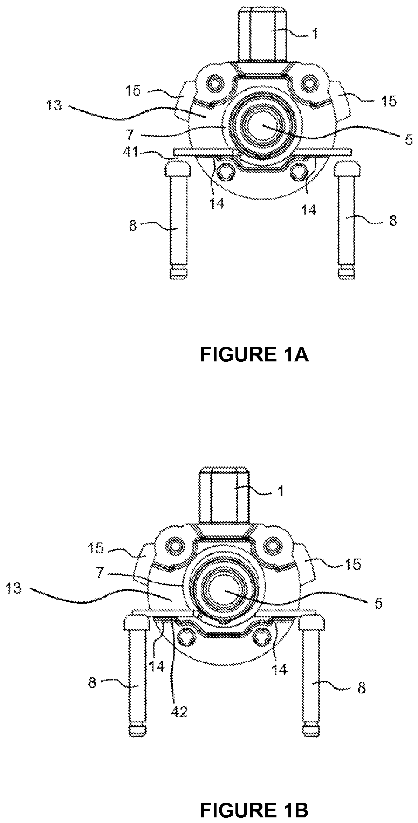

Les figures 1A et 1B illustrent l'apparition d'un tel jeu résiduel entre les branches du ressort de torsion 7 et les surfaces d'appui. En référence à la figure 1A, ledit jeu 41 peut apparaitre entre le ressort de torsion 7 et les butées 8 agencées dans le corps. Autrement, en référence à la figure 1B, ledit jeu 42 peut apparaitre entre le ressort de torsion 7 et les surfaces de contact 14 comprises dans le rotor 13 de l'actionneur 1.

Ledit jeu résiduel peut être plus ou moins important selon les tolérances de fabrication des pièces, il est cependant inévitable en raison de l'hyperstatisme de la liaison. Ledit jeu permet des mouvements compris typiquement entre 0,4 et 1 mm correspondant à une valeur angulaire allant de 2° à 5° ne pouvant pas être détectés par le capteur. Un tel jeu résiduel limite donc fortement la précision du dispositif. Les documents US2018/059710 A1 et EP 3677 983 A1 décrivent des dispositifs pouvant présenter un tel jeu résiduel. Des améliorations sont à attendre concernant la précision des dispositifs de commande notamment en proximité de la position de repos. En outre, on attend des améliorations concernant l'étanchéité du dispositif.

### EXPOSE DE L'INVENTION

Un but de l'invention est de concevoir un dispositif de commande, apte à basculer sur un axe avec un retour au centre sans jeu mécanique résiduel. A cette fin, l'invention propose un dispositif de commande comprenant :
- un corps comprenant un circuit imprimé,
- un actionneur mobile en pivotement par rapport au corps autour d'un axe de rotation,
- un ressort de torsion comprenant deux brins d'extrémité en appui sur deux surfaces d'appui respectives de l'actionneur, ledit ressort de torsion étant agencé pour solliciter l'actionneur en rotation vers une position de repos,
- au moins un aimant rigidement solidaire de l'actionneur, et
- un capteur de champ magnétique agencé sur le circuit imprimé en regard de l'aimant adapté pour détecter la position angulaire de l'aimant et pour produire un signal électrique en fonction de ladite position angulaire détectée,
- -deux butées rigidement solidaires du corps, chaque butée comprenant une surface d'appui sur un brin d'extrémité respectif dudit ressort de torsion,
caractérisé en ce qu'il comprend un élément élastique respectif agencé dans un état contraint entre chaque butée et le corps pour maintenir les brins du ressort de torsion sans interstice sur les deux butées respectives, les butées étant fixes par rapport au corps.

De manière avantageuse, les éléments élastiques sont des ressorts de compression. Chaque butée comprend une tête comprenant la surface d'appui respective et un axe s'étendant à partir de la tête, chaque ressort de compression étant agencé autour dudit axe.

Chacune des surfaces d'appui des butées et chacune des surfaces d'appui de l'actionneur sont disposées du même côté du brin d'extrémité respectif du ressort du torsion.

Lesdits éléments élastiques sont dans un état contraint.

Lesdites butées sont rigidement solidaires du corps par immersion dans une résine.

Dans certains modes de réalisation, le dispositif de commande comprend deux secondes butées limitant la rotation de l'actionneur autour de l'axe, lesdites secondes butées étant rigidement solidaires avec l'actionneur.

Les secondes butées limitant la rotation autour de l'axe sont, en fin de course, en contact avec les surfaces de contact agencées dans le corps.

L'invention se rapporte aussi à un procédé de fabrication d'un dispositif de commande tel que décrit plus haut, comprenant les étapes suivantes :
∘ la fourniture de l'actionneur et du ressort de torsion,
∘ l'agencement dudit ressort de torsion autour de l'axe de rotation de l'actionneur, les brins d'extrémité du ressort de torsion étant en appui sur les surfaces d'appui de l'actionneur,
∘ la fourniture du corps, le corps comprenant un fond comportant deux orifices et deux butées mobiles en coulissement dans lesdits orifices, lesdites butées étant sollicitées vers l'actionneur par les éléments élastiques,
∘ l'insertion de l'actionneur et du ressort de torsion dans le corps, les brins d'extrémité du ressort de torsion venant en appui sur les butées et comprimant les éléments élastiques,
∘ l'immobilisation des butées par rapport au corps.

Le montage en comprimant les éléments élastiques permet de rattraper tout jeu mécanique résiduel, en assurant un contact ferme des brins du ressort de torsion simultanément avec les butées et sur les surfaces d'appui. On optimise ainsi la précision du dispositif de commande notamment autour de la position neutre.

### BREVE DESCRIPTION DES FIGURES

D'autres caractéristiques et avantages de l'invention ressortiront de la description détaillée qui va suivre, en référence aux dessins annexés, sur lesquels :
Les figures 1A et 1B illustrent le jeu résiduel pouvant apparaitre à deux endroits dans un dispositif de commande de type connu.
La figure 2 est une vue en perspective d'un dispositif de commande selon l'invention.
Les figures 3A et 3B sont des vues en coupe d'un dispositif de commande selon l'invention.
La figure 4 est une vue éclatée d'un dispositif de commande selon l'invention.
Les figures 5A-D illustrent les étapes d'assemblage d'un dispositif de commande selon l'invention, dans lequel le rotor de l'actionneur mobile comportant l'aimant et le ressort de torsion sont insérés dans le corps en comprimant les éléments élastiques agencés sur les butées comprises dans le corps du dispositif de commande.
La figure 6 est une vue en coupe du dispositif illustrant le montage de la membrane et l'agencement de la résine rendant le boitier étanche aux liquides.
La figure 7 est une vue du dessus du corps et du rotor, illustrant l'agencement des orifices et des surfaces de contact.

### DESCRIPTION DETAILLEE DE MODES DE REALISATION

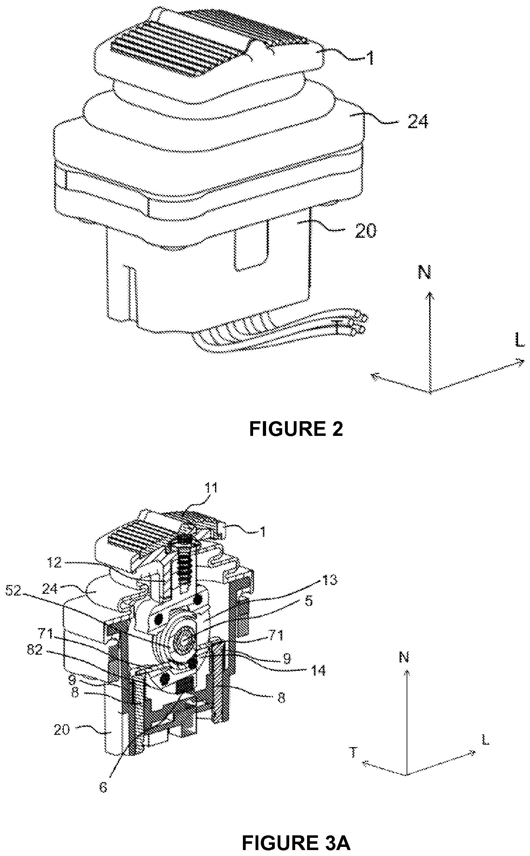

Un dispositif de commande selon l'invention comprend un corps 20 fixe, un actionneur 1 mobile en pivotement par rapport au corps 20 autour d'un axe 50 de rotation, et un moyen de détection de la position de l'actionneur 1. La figure 2 est une vue schématique d'un tel dispositif de commande assemblé.

Dans un souci de clarté et de simplification nous utilisons une orientation de bas en haut telle que représentée sur la figure 2, le corps 20 étant agencé verticalement avec l'actionneur 1 positionné « en haut » du dispositif de commande. Ainsi, les termes « bas », « haut », « dessus », « dessous », « supérieur », « inférieur » ainsi que « horizontal » et « vertical » serviront la description sans pour autant limiter l'invention.

L'axe longitudinal L et l'axe transversal T définissent alors un plan « horizontal » et l'axe neutre N est « vertical ».

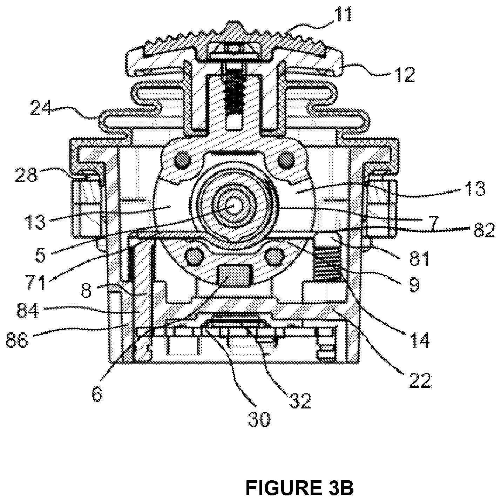

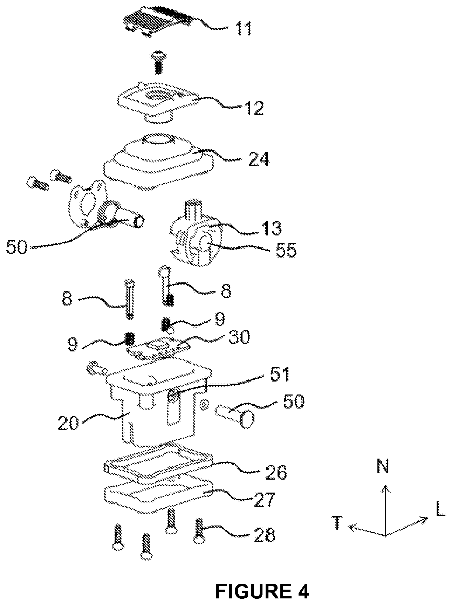

En référence aux figures 3A, 3B et 4, le corps 20 fixe est évidé à l'intérieur pour y loger un rotor 13 constituant la portion inférieure de l'actionneur 1 et les autres composants du dispositif de commande. Ledit corps 20 se présente typiquement sous forme d'un boîtier essentiellement parallélépipédique. Le corps 20 comprend un fond 22 qui est avantageusement essentiellement rectangulaire, et un logement 23 agencé en-dessous dudit fond 22, ledit logement 23 comprenant un circuit imprimé 30 portant un capteur 32 dont la fonction sera décrite ultérieurement. Des câbles peuvent être connectés au circuit imprimé 30.

Le fond 22 comprend en outre deux orifices 86 traversants du haut vers le bas, pouvant se présenter à titre d'exemple illustratif et non limitatif sous forme de deux trous cylindriques, agencés sur les côtés du fond 22 parallèles à l'axe transversal T.

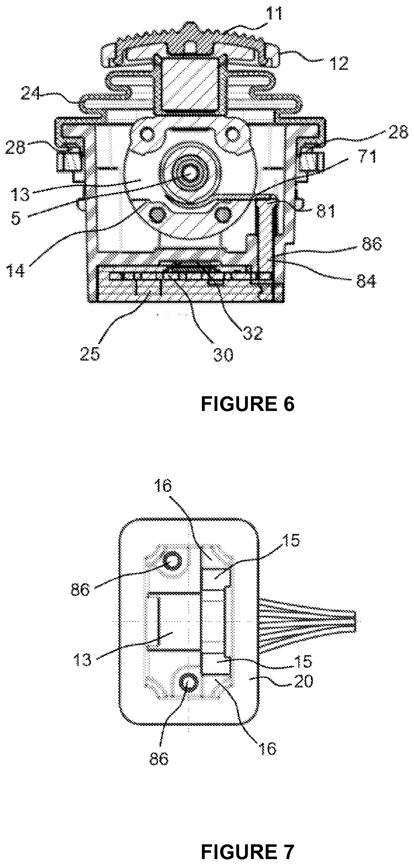

De manière avantageuse, les orifices 86 sont agencées de manière asymétrique comme illustré dans la figure 7, leur décalage par rapport au plan formé par l'axe longitudinal L et l'axe vertical N correspondant au décalage des brins 71 du ressort de torsion 7 par rapport audit plan. Avantageusement, les orifices 86 sont agencés sur les côtés étroits du fond 22.

Deux premières butées 8 sont agencées à l'intérieur du corps 20 et rigidement solidaires dudit corps 20. Lesdites premières butées 8 comprennent chacune une tête 81 comprenant une surface d'appui 82 respective et un axe 84 respectif s'étendant à partir de la tête 81, chacun des axes 84 traversant l'un des orifices 86 compris dans le fond 22. Chaque première butée 8 comprend un élément élastique 9 agencé autour de l'axe 84 respectif de la butée 8. De manière avantageuse, ledit élément élastique 9 est un ressort de compression. Chacun des éléments élastiques 9 est dans un état contraint entre la tête 81 respective de chaque première butée 8 et le fond 22 du corps 20. Bien que, dans l'état assemblé représenté sur les figures 3A et 3B, les butées 8 soient fixes par rapport au corps 20 et que la sollicitation appliquée par les éléments élastiques 9 n'engendre pas de déplacement desdites butées, les éléments élastiques 9 présentent un avantage particulier lors de l'assemblage du commutateur pour l'obtention d'un montage sans jeu résiduel entre le ressort de rappel de l'actionneur et les butées 8, comme cela sera expliqué en détail plus bas.

Le corps 20 comprend en outre deux orifices 51 agencés de manière symétrique sur deux surfaces verticales parallèles à l'axe longitudinal L, lesdites surfaces verticales étant avantageusement les côtés longs du corps 20. Chaque orifice 51 est agencé au milieu de la surface le long de l'axe longitudinal L. Les orifices 51 sont avantageusement des trous cylindriques, recevant un arbre 5 le long d'un axe 50 de rotation de l'élément mobile. L'arbre 5 est préférablement de forme cylindrique et peut comporter des fixations permettant de maintenir ledit arbre 5 dans les orifices 51. L'arbre 5 est solidaire avec le corps 20 au niveau des orifices 51. De manière avantageuse, l'arbre 5 comporte une entretoise cylindrique limitant les frottements lors de la rotation et le jeu mécanique autour de l'axe de rotation.

Le corps 20 comprend en outre une membrane 24 agencé de manière à fermer le corps sur le haut, ladite membrane 24 comportant un orifice apte à laisser traverser une portion de l'actionneur 1. Ladite membrane 24 est apte à former un joint étanche aux liquides entre les parois verticales du corps 20 et l'actionneur 1. De manière avantageuse, la membrane 24 est constituée d'un élastomère. Préférablement, la membrane est fixée à l'actionneur 1 et au corps 20 par serrage entre deux surfaces assemblées par des vis. Le corps 20 peut comprendre, sur son coté inférieur, une couche de résine 25 agencée de manière à immobiliser les premières butées 8 par rapport au corps 20. De manière avantageuse, la couche de résine 25 est apte à former un joint étanche aux liquides couvrant le circuit imprimé 30, le logement 23 et le fond 22 du corps 20.

Le corps 20 peut être fixé sur un support tel qu'un panneau ou une machine par l'intermédiaire d'un panneau de montage 26 et un berceau 27 par serrage des vis 28.

L'actionneur 1 mobile comprend un cache 11, un levier 12 et un rotor 13 essentiellement cylindrique.

Le cache 11 est destiné à être manipulé par l'utilisateur. Ledit cache 11 peut être conçu selon les exigences esthétiques de l'appareil dans lequel le dispositif de commande sera utilisé, ou comprendre des informations tels qu'un logo ou un pictogramme. Il peut en outre comprendre une surface agrippante permettant d'éviter un glissement du doigt d'un utilisateur lors de l'utilisation du dispositif de commande, ou tout autre surface appropriée selon l'ergonomie et l'esthétique que l'on souhaitera donner au dispositif.

Le levier 12 lie le cache 11 avec le rotor 13. Ledit levier 12 est préférablement de forme allongée, permettant de transmettre le mouvement rotatif se produisant par la manipulation du cache 11 au rotor 13.

Le rotor 13 est agencé à l'intérieur du corps 20 et comprend un alésage cylindrique 55, le long de l'axe 50 de rotation de l'actionneur 1. L'arbre 5 est agencé de manière à traverser ledit alésage 55 le long de l'axe 50 de rotation, permettant le pivotement du rotor 13 autour de cet axe 50.

Le rotor 13 comprend une portion cyclique 52 en relief autour de l'alésage cylindrique 55, ladite portion cyclique 52 étant apte à recevoir un ressort de torsion 7. Ledit ressort de torsion 7 est agencé de manière à entourer la portion cyclique 52 et ainsi aligner la portion annulaire dudit ressort de torsion 7 avec l'alésage cylindrique 55 du rotor 13. L'arbre 5 de pivotement est monté de manière à traverser la portion annulaire du ressort de torsion 7, la portion cyclique 52 et l'alésage 55 le long de l'axe 50 de rotation.

Le ressort de torsion 7 comprend deux brins 71 d'extrémité en appui sur deux surfaces d'appui 14 respectives agencées sur la partie inférieure du rotor 13, en-dessous des brins du ressort de torsion 7 et en solidaires avec lesdits brins 71. Les brins 71 d'extrémité sont en outre en contact avec les surfaces d'appui 82 des premières butées 8 respectives agencées dans le corps 20. Le ressort de torsion 7 présente une force de compression supérieure à la force de compression des éléments élastiques 9.

Deux secondes butées 15 peuvent être agencées de manière facultative sur la partie supérieure du rotor 13, présentant deux surfaces de contact en regard d'une paire de surfaces de contact 16 agencées dans le corps 20.

Le rotor 13 de l'actionneur comprend en outre un aimant 6 rigidement solidaire avec ledit rotor 13. De manière avantageuse, l'aimant 6 est agencé au fond du rotor 13 en regard du capteur de champ magnétique 32 du circuit imprimé 30.

Quand l'actionneur 1 est en position neutre, le levier 12 est parallèle à l'axe neutre N et le cache 11 est orienté vers le haut. Dans cette position, le ressort de torsion 7 est soumis à une contrainte minimale. L'aimant 6 est dans sa position la plus basse et la plus proche du capteur de champ magnétique 32. Le cas échéant, les deux secondes butées 15 n'ont aucun contact avec les premières butées 8.

Quand l'actionneur 1 est en position inclinée, le levier 12 forme un angle par rapport à l'axe N dans le plan défini par l'axe neutre N et l'axe longitudinal L. L'inclinaison peut se présenter dans une direction négative ou positive. Le ressort de torsion 7 subit une contrainte plus importante que dans la position neutre et sollicite l'actionneur 1 en rotation vers la position neutre. L'aimant 6 est décalé de sa position neutre dans le sens opposé de l'inclinaison du levier 12. Le cas échéant, l'une des deux secondes butées 15 est rapprochée de la tête 81 de la première butée 8 agencée en regard de ladite seconde butée, et l'autre seconde butée 15 est éloignée de la tête 81 de la première butée 8 respective, par rapport à la position neutre.

Quand l'inclinaison de l'actionneur 1 est maximale, le cas échéant, la seconde butée 15 agencée sur le côté sur lequel le levier 12 est incliné vient en appui sur la surface 16 agencé du même côté dans le corps 20, limitant ainsi la rotation de l'actionneur 1 autour de l'axe 50. L'angle entre le levier 12 et l'axe N peut s'élever, à titre d'exemple illustratif et non limitatif, à 25° ou 30° en position d'inclinaison maximale.

Quand un utilisateur commence à manipuler la partie mobile de l'actionneur 1, ledit actionneur 1 est en mouvement de la position neutre vers une position inclinée. L'aimant 6 est alors en mouvement dans le sens opposé de l'inclinaison du levier 12. Le capteur de champ magnétique 32 détecte la position angulaire de l'aimant 6 et produit un signal électrique en fonction de ladite position angulaire détectée. L'utilisateur peut ensuite effectuer une manipulation dans le même sens ou dans le sens opposé, et le capteur détecte à nouveau la position angulaire de l'aimant 6. L'utilisateur peut continuer les manipulations qui seront détectées de la même manière, ou lâcher l'actionneur 1 dans quelconque position.

Lorsque l'utilisateur lâche l'actionneur 1 en position inclinée, le ressort de torsion 7 sollicite l'actionneur 1 vers sa position neutre. Le capteur de champ magnétique 32 détecte le retour dans la position neutre de l'aimant 6 et produit un signal électrique correspondant.

Le capteur de champ magnétique 32 peut être un capteur qui détecte le mouvement d'un aimant 6. De manière alternative, le capteur de champ magnétique peut être un capteur qui détecte la position d'un aimant 6. Avantageusement, le capteur de champ magnétique 32 est un capteur à effet Hall.

On va maintenant décrire les étapes d'assemblage du dispositif de commande.

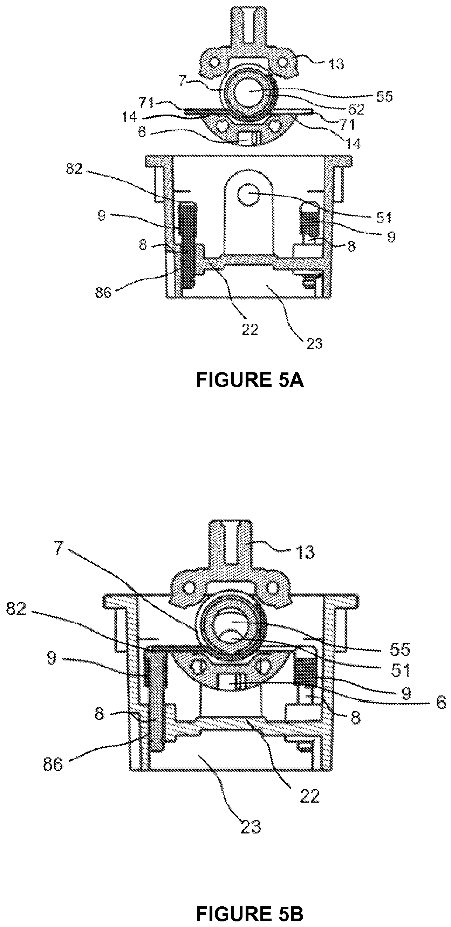

La première étape est illustrée dans la figure 5A. Partant du corps 20 pouvant comprendre le circuit imprimé 30 et le capteur 32, on insère les axes 84 des premières butées 8 dans les orifices 86 compris dans le fond 22. Les axes comportent les éléments élastiques 9 qui sont ainsi agencés entre les têtes 81 et les orifices 86. Pendant cette étape, les éléments élastiques 9 ne subissent aucune contrainte. Simultanément, on monte le ressort de torsion 7 sur la portion cyclique 52 en relief sur le rotor 13 de l'actionneur 1, les brins 71 étant en contact ferme avec les surfaces d'appui 14.

Dans une deuxième étape, en référence à la figure 5B, on insère le rotor 13 de l'actionneur 1 comportant l'aimant 6 et le ressort de torsion 7 dans le corps 20, en alignant l'alésage 55 avec les orifices 51. Les extrémités des brins 71 du ressort de torsion 7 viennent en appui sur les premières butées 8, en comprimant les éléments élastiques 9 respectifs agencés sur les axes 84 desdites butées 8. Les premières butées 8 coulissent dans les orifices 86 dans le fond 22. La force de compression des éléments élastiques 9 étant inférieure à la force de compression du ressort de torsion 7, le ressort de torsion 7 ne subit pas de déformation pendant cette étape.

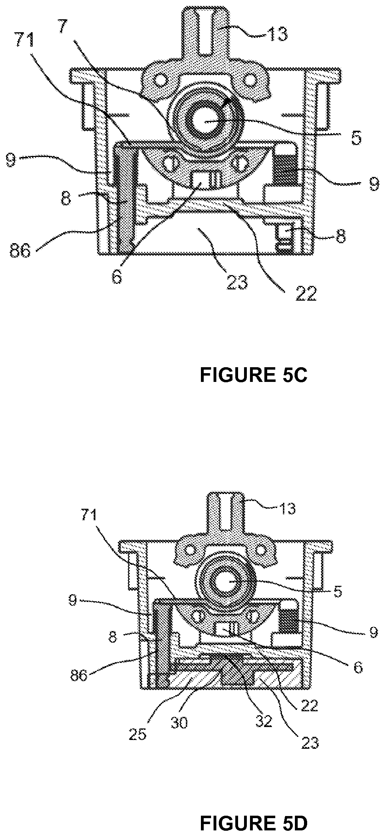

Dans une troisième étape, en référence à la figure 5C, on insère l'arbre 5 dans les orifices 51 et l'alésage cylindrique 55 le long de l'axe 50 de rotation. Les éléments élastiques 9 sont contraints, permettant ainsi d'agencer le ressort de torsion 7 avec une contrainte symétrique sur les butées 8 des deux côtés respectifs dans le rotor 13 et les surfaces d'appui 14 des deux côtés respectifs de l'actionneur 1. En raison de la sollicitation exercée par les éléments élastiques 9, aucun interstice ne peut exister entre les brins 71 du ressort de torsion 7 et les butées 8. Cet agencement a pour effet d'éviter tout jeu mécanique résiduel dans le commutateur.

Le circuit imprimé 30 comportant le capteur 32 peut être inséré dans le corps avant ou après chacune desdites étapes.

Dans une quatrième étape en référence à la figure 5D, les butées 8 sont immobilisées par rapport au corps 20, dans la position imposée par la sollicitation des éléments élastiques 9, qui permet d'éviter tout jeu entre les butées et les brins 71 du ressort de torsion. L'immobilisation peut être effectuée, à titre purement illustratif et non limitatif, par coulée d'une résine 25 dans la partie inférieure du corps, par immersion de la partie inférieure du corps dans une résine, par collage ou par soudure. Quand l'immobilisation est effectuée par un autre moyen que par une résine, une couche de résine peut être appliquée après l'immobilisation. Dans ce cas, le circuit imprimé 30 comportant le capteur peut être inséré dans le corps après l'immobilisation des butées et, le cas échéant, avant l'application de la couche de résine.

L'application d'une couche de résine 25 a en outre l'effet de rendre le boitier étanche aux liquides au niveau du fond 22.

Le dispositif après lesdites étapes d'assemblage ne comporte aucun jeu mécanique résiduel notamment autour de la position neutre de l'élément mobile.

La membrane 24 est fixé sur le corps 20 après l'assemblage des différents composants agencés à l'intérieur du corps 20. Le levier 12 et le cache 11 sont agencés sur le rotor 13 de l'actionneur 1.

Le dispositif de commande peut ensuite être monté sur un support tel qu'un panneau ou une machine par intermédiaire du panneau de montage 26, d'une entretoise de fixation optionnelle, et du berceau 27 par serrage des vis 28. Une portion de la membrane 24 est agencée entre le corps 20 et le panneau de montage 26. Le serrage des vis 28 a pour effet de serrer le corps 20 contre le panneau de montage 26 et ainsi comprimer ladite portion de la membrane 24, rendant le dispositif étanche aux liquides du côté supérieur.

## Revendications

1. Dispositif de commande comprenant :
∘ un corps (20) comprenant un circuit imprimé (30),
∘ un actionneur (1) mobile en pivotement par rapport au corps (20) autour d'un axe 50 de rotation,
∘ un ressort de torsion (7) comprenant deux brins (71) d'extrémité en appui sur deux surfaces d'appui (14) respectives de l'actionneur (1), ledit ressort de torsion (7) étant agencé pour solliciter l'actionneur (1) en rotation vers une position de repos,
∘ au moins un aimant (6) rigidement solidaire de l'actionneur (1),
∘ un capteur de champ magnétique (32) agencé sur le circuit imprimé (30) en regard de l'aimant (6), adapté pour détecter la position angulaire de l'aimant (6) et pour produire un signal électrique en fonction de ladite position angulaire détectée,
∘ deux butées (8) rigidement solidaires du corps (20), chaque butée (8) comprenant une surface d'appui sur un brin (71) d'extrémité respectif dudit ressort de torsion (7),
**caractérisé en ce qu'**il comprend un élément élastique (9) respectif agencé dans un état contraint entre chaque butée (8) et le corps (20) pour maintenir les brins du ressort de torsion sans interstice sur les deux butées (8) respectives, les butées (8) étant fixes par rapport au corps (20).

2. Dispositif de commande selon la revendication 1, dans lequel les éléments élastiques (9) sont des ressorts de compression.

3. Dispositif de commande selon la revendication 2, dans lequel chaque butée (8) comprend une tête (81) comprenant la surface d'appui respective et un axe (84) s'étendant à partir de la tête (81), chaque ressort de compression étant agencé autour dudit axe (84).

4. Dispositif de commande selon l'une des revendications précédentes dans lequel chacune des surfaces d'appui des butées (8) et chacune des surfaces d'appui (14) de l'actionneur (1) sont disposées du même côté du brin (71) d'extrémité respectif du ressort du torsion (7).

5. Dispositif de commande selon l'une des revendications précédentes dans lequel lesdits éléments élastiques (9) sont dans un état contraint.

6. Dispositif de commande selon l'une des revendications précédentes dans lequel lesdites butées (8) sont rigidement solidaires du corps (20) par immersion dans une résine (25).

7. Dispositif de commande selon l'une des revendications précédentes comprenant deux secondes butées (15) limitant la rotation de l'actionneur (1) autour de l'axe (50), lesdites secondes butées (15) étant rigidement solidaires de l'actionneur (1).

8. Dispositif de commande selon la revendication précédente dans lequel les secondes butées (15) limitant la rotation autour de l'axe (50) sont, en fin de course, en contact avec des surfaces de contact (16) agencées dans le corps (20).

9. Procédé de fabrication d'un dispositif de commande selon l'une des revendications 1 à 8, comprenant les étapes :
∘ fourniture de l'actionneur (1) et du ressort de torsion (7),
∘ agencement dudit ressort de torsion (7) autour de l'axe (50) de rotation de l'actionneur (1), les brins (71) d'extrémité du ressort de torsion (7) étant en appui sur les surfaces d'appui (14) de l'actionneur (1),
**caractérisé en ce que** ledit procédé comprend en outre les étapes suivantes :
∘ fourniture du corps (20) comprenant un fond (22) comportant deux orifices (86) et deux butées (8) mobiles en coulissement dans lesdits orifices, lesdites butées (8) étant sollicitées vers l'actionneur (1) par les éléments élastiques (9),
∘ insertion de l'actionneur (1) et du ressort de torsion (7) dans le corps (20), les brins (71) d'extrémité du ressort de torsion (7) venant en appui sur les butées (8) et comprimant les éléments élastiques (9),
∘ immobilisation des butées (8) par rapport au corps (20).

## Patentansprüche

1. Steuerungsvorrichtung, umfassend :
• einen Körper (20), umfassend eine Leiterplatte (30),
• einen Aktuator (1), der relativ zum Körper (20) um eine Drehachse (50) schwenkbar beweglich ist,
• eine Torsionsfeder (7), umfassend zwei Endabschnitte (71), die jeweils auf zwei entsprechende Anlageflächen (14) des Aktuators (1) abgestützt sind, wobei die Torsionsfeder (7) so angeordnet ist, dass sie den Aktuator (1) durch Drehung in eine Ruheposition drängt,
• mindestens einen Magneten (6), starr mit dem Aktuator (1) verbunden,
• einen Magnetfeldsensor (32), auf der Leiterplatte (30) gegenüber dem Magneten (6) angeordnet, geeignet zur Erkennung der Winkelposition des Magneten (6) und zur Erzeugung eines elektrischen Signals in Abhängigkeit von der erkannten Winkelposition,
• zwei Anschläge (8), starr mit dem Körper (20) verbunden, wobei jeder Anschlag (8) eine Anlagefläche für einen jeweiligen Endabschnitt (71) der Torsionsfeder (7) umfasst,
**dadurch gekennzeichnet, dass** er jeweils ein elastisches Element (9) umfasst, das in einem vorgespannten Zustand zwischen jedem Anschlag (8) und dem Körper (20) angeordnet ist, um die Endabschnitte der Torsionsfeder ohne Zwischenraum auf den jeweiligen Anschlägen (8) zu halten, wobei die Anschläge (8) relativ zum Körper (20) fest sind.

2. Steuerungsvorrichtung nach Anspruch 1, wobei die elastischen Elemente (9) Druckfedern sind.

3. Steuerungsvorrichtung nach Anspruch 2, wobei jeder Anschlag (8) einen Kopf (81) mit der jeweiligen Anlagefläche und eine Achse (84), die sich vom Kopf (81) erstreckt, umfasst, wobei jede Druckfeder um die genannte Achse (84) angeordnet ist.

4. Steuerungsvorrichtung nach einem der vorhergehenden Ansprüche, wobei jede der Anlageflächen der Anschläge (8) und jede der Anlageflächen (14) des Aktuators (1) auf derselben Seite des jeweiligen Endabschnitts (71) der Torsionsfeder (7) angeordnet sind.

5. Steuerungsvorrichtung nach einem der vorhergehenden Ansprüche, wobei die genannten elastischen Elemente (9) in einem vorgespannten Zustand sind.

6. Steuerungsvorrichtung nach einem der vorhergehenden Ansprüche, wobei die genannten Anschläge (8) durch Eintauchen in ein Harz (25) starr mit dem Körper (20) verbunden sind.

7. Steuerungsvorrichtung nach einem der vorhergehenden Ansprüche, umfassend zwei zweite Anschläge (15), die die Drehung des Aktuators (1) um die Achse (50) begrenzen, wobei die genannten zweiten Anschläge (15) starr mit dem Aktuator (1) verbunden sind.

8. Steuerungsvorrichtung nach dem vorhergehenden Anspruch, wobei die zweiten Anschläge (15), die die Drehung um die Achse (50) begrenzen, in einer Endposition in Kontakt mit Kontaktflächen (16) stehen, die im Körper (20) angeordnet sind.

9. Herstellungsverfahren einer Steuerungsvorrichtung nach einem der Ansprüche 1 bis 8, umfassend die Schritte :
• Bereitstellung des Aktuators (1) und der Torsionsfeder (7),
• Anordnung der genannten Torsionsfeder (7) um die Drehachse (50) des Aktuators (1), wobei die Endabschnitte (71) der Torsionsfeder (7) auf den Anlageflächen (14) des Aktuators (1) abgestützt sind,
**dadurch gekennzeichnet, dass** das genannte Verfahren ferner die folgenden Schritte umfasst :
• Bereitstellung des Körpers (20), umfassend einen Boden (22) mit zwei Öffnungen (86) und zwei Anschlägen (8), die in den genannten Öffnungen verschiebbar beweglich sind, wobei die genannten Anschläge (8) durch die elastischen Elemente (9) in Richtung des Aktuators (1) gedrängt werden,
• Einsetzen des Aktuators (1) und der Torsionsfeder (7) in den Körper (20), wobei die Endabschnitte (71) der Torsionsfeder (7) auf den Anschlägen (8) abgestützt sind und die elastischen Elemente (9) zusammendrücken,
• Fixierung der Anschläge (8) relativ zum Körper (20).

## Claims

1. Control device comprising:
• a body (20) comprising a printed circuit board (30),
• an actuator (1) pivotally movable relative to the body (20) about a rotation axis (50),
• a torsion spring (7) comprising two end strands (71) bearing against two respective bearing surfaces (14) of the actuator (1), said torsion spring (7) being arranged to urge the actuator (1) in rotation towards a rest position,
• at least one magnet (6) rigidly secured to the actuator (1),
• a magnetic field sensor (32) arranged on the printed circuit board (30) facing the magnet (6), adapted to detect the angular position of the magnet (6) and to produce an electrical signal according to said detected angular position,
• two stops (8) rigidly secured to the body (20), each stop (8) comprising a bearing surface for a respective end strand (71) of said torsion spring (7),
**characterized in that** it comprises a respective elastic element (9) arranged in a constrained state between each stop (8) and the body (20) to maintain the strands of the torsion spring without clearance on the two respective stops (8), the stops (8) being fixed relative to the body (20).

2. Control device according to claim 1, wherein the elastic elements (9) are compression springs.

3. Control device according to claim 2, wherein each stop (8) comprises a head (81) comprising the respective bearing surface and a shaft (84) extending from the head (81), each compression spring being arranged around said shaft (84).

4. Control device according to one of the preceding claims, wherein each of the bearing surfaces of the stops (8) and each of the bearing surfaces (14) of the actuator (1) are arranged on the same side of the respective end strand (71) of the torsion spring (7).

5. Control device according to one of the preceding claims, wherein said elastic elements (9) are in a constrained state.

6. Control device according to one of the preceding claims, wherein said stops (8) are rigidly secured to the body (20) by immersion in a resin (25).

7. Control device according to one of the preceding claims, comprising two second stops (15) limiting the rotation of the actuator (1) about the axis (50), said second stops (15) being rigidly secured to the actuator (1).

8. Control device according to the preceding claim, wherein the second stops (15) limiting the rotation about the axis (50) are, at end of travel, in contact with contact surfaces (16) arranged in the body (20).

9. Method for manufacturing a control device according to one of claims 1 to 8, comprising the steps of:
• providing the actuator (1) and the torsion spring (7),
• arranging said torsion spring (7) around the rotation axis (50) of the actuator (1), the end strands (71) of the torsion spring (7) bearing against the bearing surfaces (14) of the actuator (1),
**characterized in that** said method further comprises the following steps:
• providing the body (20) comprising a bottom (22) having two openings (86) and two stops (8) slidably movable in said openings, said stops (8) being urged towards the actuator (1) by the elastic elements (9),
• inserting the actuator (1) and the torsion spring (7) into the body (20), the end strands (71) of the torsion spring (7) bearing against the stops (8) and compressing the elastic elements (9),
• immobilizing the stops (8) relative to the body (20).
